# EUROPEAN PATENT APPLICATION

(11) **EP 1 947 698 A2**
(43) Date of publication of application: **23.07.2008**
(21) Application number: 08000633.1
(22) Date of filing: 15.01.2008
(51) Int. Cl.: H01L 27/32, H01L 51/54

(54) **Display device**

(30) Priority: 17.01.2007 KR 20070005339
(71) Applicant: Samsung Electronics Co., Ltd., Yeongtong-gu Suwon-city, Gyeonggi-do 442-742 (KR)
(72) Inventor: Ha, Jae-kook, Yongin-si Gyeonggi-do (KR); Chu, Chang-woong, Suwon-si Gyeonggi-do (KR); Lee, Joo-hyeon, Yongin-si Gyeonggi-do (KR); Choi, Jun-ho, Yongin-si Gyeonggi-do (KR)
(74) Representative: Weitzel, Wolfgang

(57) **Abstract**

In one embodiment, a display device includes: a first electrode; a hole transfer layer (910) which is formed on the first electrode, the hole transfer layer (910) comprising a first host used as a hole transfer material and a first dopant used as an electron accepting material; an emitting material layer (920) which is formed on the hole transfer layer (910), the emitting material layer comprising red, blue and green light material layers stacked in sequence; an electron transfer layer (930) which is formed on the emitting material layer (920), the electron transfer layer (930) comprising a second host used as an electron transfer material and a second dopant used as an electron donating material; and a second electrode which is formed on the electron transfer layer (930).

## Description

### BACKGROUND OF INVENTION

### Field of Invention

Apparatuses consistent with the present invention relate to a display device, and more particularly, to a display device which includes an emitting material layer with a plurality of sub-layers.

### Description of the Related Art

Recently, among flat panel display devices, an organic light emitting diode has been in the limelight owing to low voltage driving, light-weight and thinness attributes, a wide viewing angle, a fast response, and the like.

The organic light emitting diode includes an emitting material layer to emit light. The emitting material layer receives and recombines electrons and holes, thereby emitting light.

If the emitting material layer emits white light, the emitting material layer may be provided by stacking a plurality of sub-layers that emit different colors.

However, in the case where the plurality of sub-layers are used for the emitting material layer, it is difficult to balance the electrons and the holes with regard to each sub-layer thereby decreasing an electric charge efficiency.

### SUMMARY OF THE INVENTION

Accordingly, it is an aspect of the present invention to provide a display device with an excellent electric charge efficiency.

Additional aspects of the present invention will be set forth in part in the description which follows and, in part, will be obvious from the description, or may be learned by practice of the present invention.

The foregoing and/or other aspects of the present invention can be achieved by providing a display device comprising: a first electrode; a hole transfer layer which is formed on the first electrode, the hole transfer layer comprising a first host used as a hole transfer material and a first dopant used as an electron accepting material; an emitting material layer which is formed on the hole transfer layer and comprises red, blue and green light material layers that are stacked in sequence; an electron transfer layer which is formed on the emitting material layer, the electron transfer layer comprising a second host used as an electron transfer material and a second dopant used as an electron donating material; and a second electrode which is formed on the electron transfer layer.

According to an aspect of the invention, a highest occupied molecular orbital (HOMO) of the first host has an energy level lower than an energy level of a lowest unoccupied molecular orbital (LUMO) of the first dopant.

According to an aspect of the invention, the first electrode and the hole transfer layer are in ohmic contact with each other.

According to an aspect of the invention, the first host comprises at least one of N,N'-dif(1-naphthalenyl)-N,N'-diphenyl]-1,1'-biphenyl-4,4'-diamine(NPD)), 9,10-bis(m-tolyphenylamino)anthracene (TPA), and spiro-TPA.

According to an aspect of the invention, the first dopant comprises tetrafluoro-tetracyano-quinodimethane (F4-TCNQ).

According to an aspect of the invention, the hole transfer layer is formed by an evaporation method using a source material of the first host and a source material of the first dopant.

According to an aspect of the invention, a lowest unoccupied molecular orbital (LUMO) of the second host has an energy level higher than an energy level of a highest occupied molecular orbital (HOMO) of the second dopant.

According to an aspect of the invention, the second electrode and the electron transfer layer are in ohmic contact with each other.

According to an aspect of the invention, the second host comprises tris(8-hydroxyquinolinolato)aluminum (Alq3).

According to an aspect of the invention, the second dopant comprises at least one of cesium (Cs), barium (Ba) and calcium (Ca).

According to an aspect of the invention, the electron transfer layer is formed by an evaporation method using a source material of the second host and a source material of the second dopant.

According to an aspect of the invention, at least one of the red, blue and green light emitting layers has a structure of light emitting host-light emitting dopant.

According to an aspect of the invention, the emitting material layer is formed by an evaporation method.

According to an aspect of the invention, the display device further comprises a color filter disposed on an optical path of light emitted from the emitting material layer.

According to an aspect of the invention, the display device further comprises a first blocking layer which is interposed between the hole transfer layer and the emitting material layer and has an energy level of the lowest unoccupied molecular orbital (LUMO) higher than that of the hole transfer layer.

According to an aspect of the invention, the display device further comprises a second blocking layer which is interposed between the electron transfer layer and the emitting material layer and has an energy level of the highest occupied molecular orbital (HOMO) lower than that of the electron transfer layer.

According to an aspect of the invention, the first electrode comprises a transparent conductive material, and the second electrode comprises a reflective metal.

According to an aspect of the invention, the display device further comprises an intermediate layer which is interposed between the red light emitting layer and the blue light emitting layer and transfers holes.

The foregoing and/or other aspects of the present invention can be achieved by providing a display device comprising: a first electrode; a hole transfer layer which is formed on the first electrode; an emitting material layer which is formed on the hole transfer layer; an electron transfer layer which is formed on the emitting material layer; and a second electrode which is formed on the electron transfer layer, the emitting material layer comprising red, blue and green light emitting layers that are stacked in sequence, and at least one of contact between the hole transfer layer and the first electrode and contact between the electron transfer layer and the second electrode being ohmic contact.

According to an aspect of the invention, the hole transfer layer comprises a first host used as a hole transfer material and a first dopant used as an electron accepting material, and a highest occupied molecular orbital (HOMO) of the first host has an energy level lower than an energy level of a lowest unoccupied molecular orbital (LUMO) of the first dopant.

According to an aspect of the invention, the electron transfer layer comprises a second host used as an electron transfer material and a second dopant used as an electron donating material, and a lowest unoccupied molecular orbital (LUMO) of the second host has an energy level higher than an energy level of a highest occupied molecular orbital (HOMO) of the second dopant.

### BRIEF DESCRIPTION OF THE DRAWINGS

The above and/or other aspects of the present invention will become apparent and more readily appreciated from the following description of the embodiments, taken in conjunction with the accompanying drawings, in which:
FIG. 1 is an equivalent circuit diagram of a display device according to a first embodiment of the present invention;
FIG. 2 is a layout diagram of the display device according to the first embodiment of the present invention;
FIG. 3 is a cross sectional view of the display device, taken along line III-III of FIG. 2;
FIG. 4 is an enlarged view of "A" in FIG. 3;
FIG. 5 illustrates energy levels of an organic layer in the display device according to the first embodiment of the present invention;
FIGS. 6A through 6C are graphs showing light emitting properties according to stacked order of sub emitting material layers;
FIG. 7 is a diagram illustrating a manufacturing method of the display device according to the first embodiment of the present invention;
FIG. 8 is a diagram illustrating a configuration of an organic layer in a display device according to a second embodiment of the present invention;
FIGS. 9A and 9B illustrate energy levels of the organic layer in the display device according to the second embodiment of the present invention; and
FIG. 10 is a diagram illustrating a configuration of an organic layer in a display device according to a third embodiment of the present invention.

### DETAILED DESCRIPTION OF EMBODIMENTS OF THE INVENTION

Reference will now be made in detail to the embodiments of the present invention, examples of which are illustrated in the accompanying drawings, wherein like reference numerals refer to like elements throughout. The embodiments are described below so as to explain the present invention by referring to the figures.

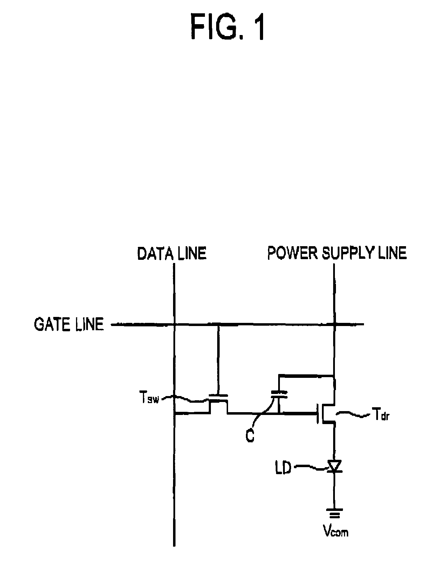

FIG. 1 is an equivalent circuit diagram of a display device according to a first embodiment of the present invention.

In one pixel, a plurality of signal lines are provided. A signal line includes a gate line transferring a scanning signal, a data line transferring a data signal, and a power supply line transferring a driving voltage. The data line and the power supply line are arranged to be parallel and adjacent to each other, and the gate line is extended to be perpendicular to the data line and the power supply line.

Each pixel includes an organic light emitting diode LD, a switching thin film transistor Tsw, a driving thin film transistor Tdr, and a capacitor C.

The driving thin film transistor Tdr has a control terminal, an input terminal, and an output terminal, and the control terminal is connected to the switching thin film transistor Tsw. Also, the input terminal is connected to the power supply line, and the output terminal is connected to the organic light emitting diode LD.

The organic light emitting diode LD has an anode connected to the output terminal of the driving thin film transistor Tdr and a cathode through which a common voltage Vcom is inputted. The intensity of light generated from the organic light emitting diode LD varies according to an output voltage of the driving thin film transistor Tdr to display an image. A magnitude of a current of the driving thin film transistor Tdr varies according to a voltage between the control terminal and the output terminal.

The switching thin film transistor Tsw also has a control terminal, an input terminal, and an output terminal. The control terminal is connected to the gate line, the input terminal is connected to the data line, and the output terminal is connected to the control terminal of the driving thin film transistor Tdr. The switching thin film transistor Tsw transfers a data signal inputted to the data line according to a scanning signal inputted to the gate line to the driving thin film transistor Tdr.

The capacitor C is connected with the control terminal and the input terminal of the driving thin film transistor Tdr. The capacitor C is charged with data signal inputted to the control terminal of the driving thin film transistor Tdr and holds it up.

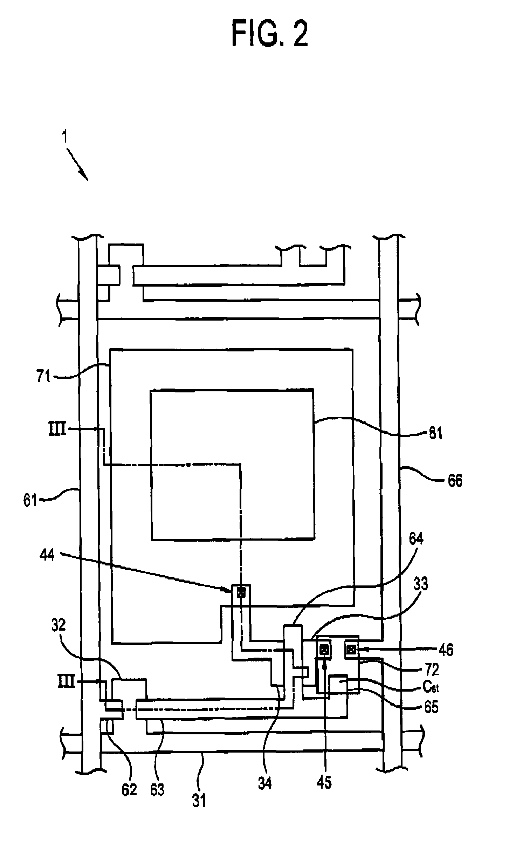

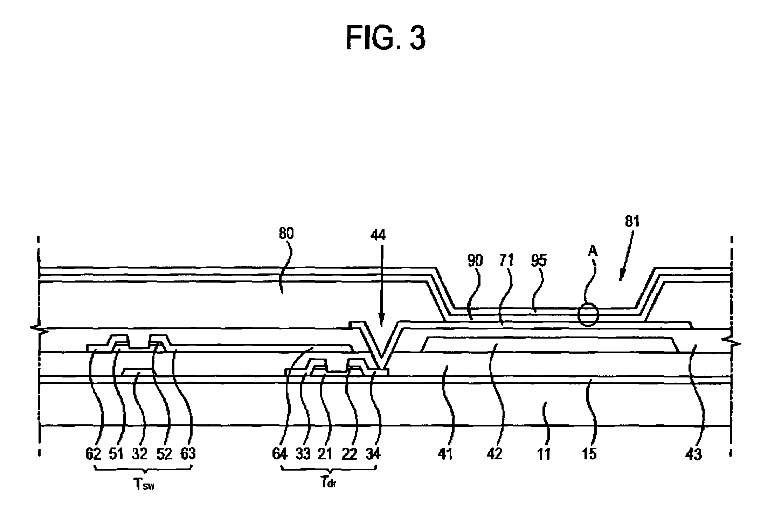

Referring to the FIGS. 2 and 3, the display device according to the first embodiment of the present invention will be described in detail.

A buffer layer 15 is formed on an insulating substrate 11. The buffer layer 15 may include silicon oxide, and prevents impurities of the insulating substrate 11 from being introduced into an amorphous silicon layer while crystallizing the amorphous silicon layer.

A driving semiconductor layer 21 and a driving ohmic contact layer 22 are formed on the buffer layer 15. The driving semiconductor layer 21 and the driving ohmic contact layer 22 include poly silicon. The driving semiconductor layer 21 and the driving ohmic contact layer 22 are formed by depositing, crystallizing, and patterning the amorphous silicon layer and the amorphous ohmic contact layer. Here, solid phase crystallization may be used in crystallizing the amorphous silicon layer and the amorphous ohmic contact layer.

A first metal layer is formed on the buffer layer 15, the driving semiconductor layer 21 and the driving ohmic contact layer 22. The first metal layer includes a gate line 31, a switching gate electrode 32, a driving source electrode 33 and a driving drain electrode 34. The gate line 31 and the switching gate electrode 32 are formed as a single body.

A first insulating layer 41 is formed on the first metal layer. The first insulating layer 41 may include silicon nitride in one example.

On the first insulating layer 41, a switching semiconductor layer 51 and a switching ohmic contact layer 52 are formed. The switching semiconductor layer 51 and the switching ohmic contact layer 52 correspond to the switching gate electrode 32, and may include amorphous silicon in one example.

A second metal layer is formed on the first insulating layer 41, the switching semiconductor layer 51 and the switching ohmic contact layer 52. In addition, on the first insulating layer 41 located on a lower part of a pixel electrode 71, a color filter 42 is formed.

The second metal layer includes a data line 61, a switching source electrode 62, a switching drain electrode 63, a driving gate electrode 64, a storage capacity line 65, and a power supply line 66.

The data line 61 and the switching source electrode 62 are formed as a single body. The switching drain electrode 63, the driving gate electrode 64, and the storage capacity line 65 are also formed as a single body.

A second insulating layer 43 is formed on the second metal layer. The second insulating layer 43 is called as a planarization layer and may include organic materials. As organic materials, one of benzocyclobutene (BCB) series, olefine series, acrylic resin series, polyimide series, and fluorine resin may be used in one example.

Contact holes 44, 45, and 46 are formed on the second insulating layer 43. The contact hole 44 exposes the driving drain electrode 34; the contact hole 45 exposes the driving source electrode 33; and the contact hole 46 exposes the power supply line 66. In the contact holes 44 and 45, the first insulating layer 41 is removed.

A transparent conducting layer is formed on the second insulating layer 43. The transparent conducting layer includes a pixel electrode 71 and a bridge electrode 72, and may be made of indium tin oxide (ITO) or indium zinc oxide (IZO) in one example.

The pixel electrode 71 is electrically connected to the driving drain electrode 34 via the contact hole 44. The bridge electrode 72 electrically connects the switching source electrode 33 with the power supply line 66 via the contact holes 45 and 46. The storage capacity line 65 is extended below the bridge electrode 72 to form a storage capacitor Cst.

A wall 80 is formed on the second insulating layer 43. The wall 80 separates the pixel electrodes 71 from each other, and is partially removed to form an aperture 81 through which the pixel electrode 71 is exposed.

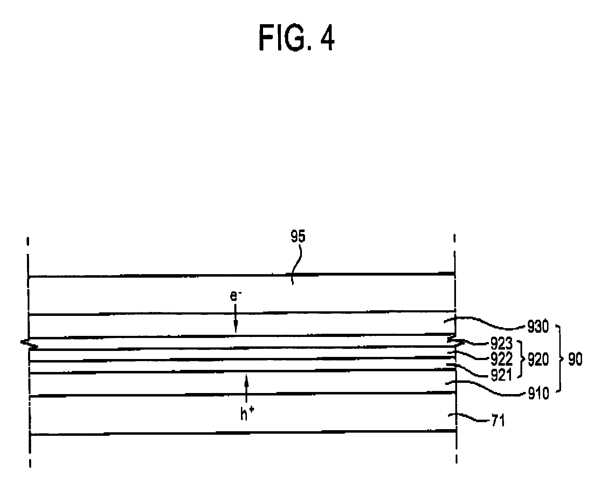

An organic layer 90 is formed on both the wall 80 and the pixel electrode 71 exposed through the aperture region 81. The organic layer 90 includes an emitting material layer 920 (refer to FIG. 4) to emit white light, which will be described later.

A region where the pixel electrode 71 and the organic layer 90 are in direct contact with each other will be called a pixel region. In this embodiment, the pixel region approximately corresponds to the aperture 81, and light is mostly generated in the pixel region.

A common electrode 95 is formed on the wall 80 and the organic layer 90. The common electrode 95 includes a reflective metal layer in one example.

Holes from the pixel electrode 71 and electrons from the common electrode 95 are combined in the organic layer 90 into excitons. As the excitons are deactivated, light is emitted. Some of the light generated in the organic layer 90, which travel toward the common electrode 95, are reflected from the common electrode 95 toward the pixel electrode 71.

The light toward the pixel electrode 71 is filtered for particular colors while passing through the color filters 42, and then travels to the outside through the insulating substrate 11. This is called a bottom-emission type.

According to another embodiment of the present invention, the pixel electrode 71 may include a reflective metal, and the common electrode 95 may be transparent. In this case, light travels to the outside through the common electrode 95, which is called a top-emission type. Accordingly, the color filter 42 is formed on the common electrode 95 in this embodiment.

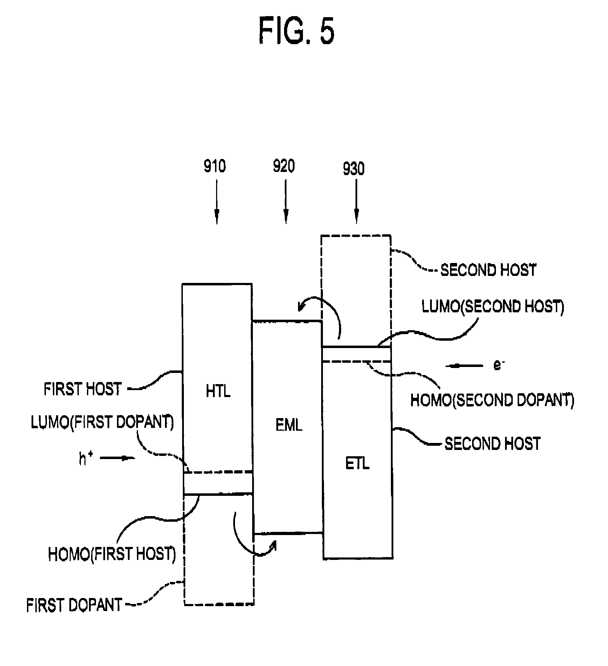

Below, the organic layer 90 will be described in more detail with reference to FIGS. 4 and 5.

As shown in FIG. 4, the organic layer 90 includes a hole transfer layer (HTL) 910, an emitting material layer (EML) 920, and an electron transfer layer (ETL) 930.

The hole transfer layer 910 is in direct contact with the pixel electrode 71 and transfers the holes from the pixel electrode 71 to the emitting material layer 920. The hole transfer layer 910 includes a first host used as a hole transfer material and a first dopant used as an electron accepting material.

As shown in FIG. 5, the highest occupied molecular orbital (HOMO) of the first host has an energy level lower than an energy level of the lowest unoccupied molecular orbital (LUMO) of the first dopant. With this energy distribution, the electrons positioned in the HOMO of the first host can easily move to the LUMO of the first dopant. Such electron movement causes equilibrium charge concentration of the hole transfer layer 910 to increase, so that the holes from the pixel electrode 71 can be introduced into the hole transfer layer 910 without an energy barrier. That is, the pixel electrode 71 and the hole transfer layer 910 are in ohmic contact with each other.

The first host may include N,N'-di[(1-naphthalenyl)-N,N'-diphenyl]-1,1'-biphenyl-4,4'-diamine(NPD)), 9,10-bis (m-tolyphenylamino) anthracene (TPA), and spiro-TPA, but is not limited thereto. The first dopant may include tetrafluoro-tetracyano-quinodimethane (F4-TCNQ), but is not limited thereto.

The electron transfer layer 930 is in direct contact with the common electrode 95 and transfers the electrons from the common electrode 95 to the emitting material layer 920. The electron transfer layer 930 includes a second host used as an electron transfer material and a second dopant used as an electron donating material. As shown in FIG. 5, the lowest unoccupied molecular orbital (LUMO) of the second host has an energy level higher than an energy level of the highest occupied molecular orbital (HOMO) of the second dopant. With this energy distribution, the electrons positioned in the HOMO of the second dopant can easily move to the LUMO of the second host. Such electron movement causes equilibrium charge concentration of the electron transfer layer 930 to increase, so that the electrons of the common electrode 95 can be introduced into the electron transfer layer 930 without an energy barrier. That is, the common electrode 95 and the electron transfer layer 930 are in ohmic contact with each other.

The second host may include tris(8-hydroxyquinolinolato)aluminum (Alq3), or compounds of oxidazole series, but is not limited thereto. The second dopant may include at least one selected from a group consisting of cesium (Cs), barium (Ba) and calcium (Ca), but is not limited thereto.

According to another embodiment of the present invention, the ohmic contact may be either formed between the hole transfer layer 910 and the pixel electrode 71 or between the electron transfer layer 930 and the common electrode 95. In other words, the electron transfer layer 930 may not be doped but only the hole transfer layer 910 may be doped with the electron accepting material, or the hole transfer layer 910 may not be doped but only the electron transfer layer 930 may be doped with the electron donating material.

The emitting material layer 920 includes three sub layers 921, 922 and 923. The sub-layers 921, 922 and 923 include a red light emitting layer 921, a blue light emitting layer 922 and a green light emitting layer 923.

The red light emitting layer 921 is in contact with the hole transfer layer 910. The green light emitting layer 923 is in contact with the electron transfer layer 930. The blue light emitting layer 922 is placed between the red and green light emitting layers 921 and 923.

Each of the sub-layers 921, 922 and 923 may have a host-dopant structure. The dopant of each sub-layers 921, 922, 923 serves as a coloring matter. The host includes a carbazole biphenyl (CBP) in one example, but is not limited thereto.

All hosts of the sub-layers 921, 922 and 923 may include the same material or different materials. Further, only two of the sub-layers 921, 922 and 923 may use the host in common.

In one example, the dopant for the red light emitting layer 910 may include a rubrene; the dopant for the blue light emitting layer 920 may include 1,1,4,4-tetraphenyl-1,3-butadien (TPB); and the dopant for the green light emitting layer 930 may include quinacridone, coumarine, Ir(ppy3), etc.

Alternatively, some of the sub-layers 921, 922 and 923 may have the host-dopant structure, or all sub-layers 921, 922 and 923 may not have the host-dopant structure.

The emitting material layer 920 combines the holes from the hole transfer layer 910 with the electrons from the electron transfer layer 930, thereby emitting light. However, if the emitting material layer 920 includes the plurality of sub-layers 921, 922 and 923, it is difficult for each of the sub-layers 921, 922 and 923 to balance the supply of the electrons and the holes.

In this embodiment, the hole transfer layer 910 is in ohmic contact with the pixel electrode 71, and the electron transfer layer 930 is in ohmic contact with the common electrode 95. In this case, a lot of charges (holes and electrons) are supplied to the emitting material layer 920, so that it is further difficult to maintain supply balance between the electrons and the holes.

It has been found that charge efficiency of the emitting material layer 920 is largely affected by the order of the sub-layers 921, 922 and 923. According to an embodiment of the present invention, the sub-layers 921, 922 and 923 are stacked in the order of red, blue and green light emitting layers 921, 922 and 923 (i.e., an RBG structure), in which the red light emitting layer 921 is the closest to the pixel electrode 71.

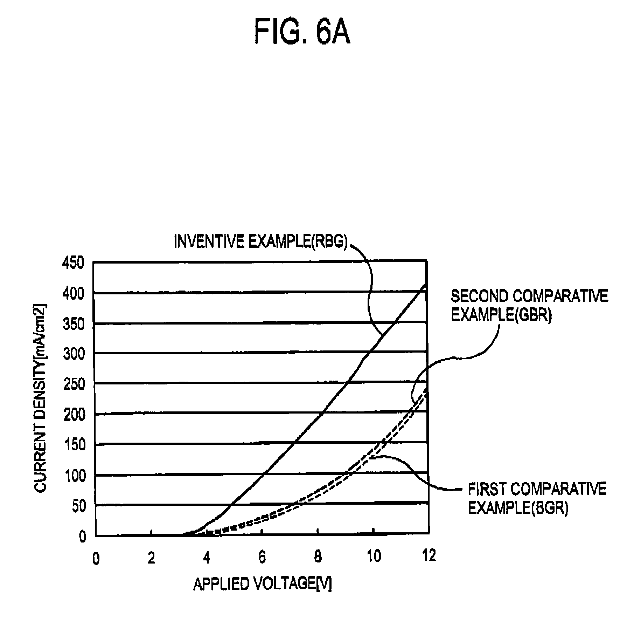

The RBG structure was tested by experiments, of which charge efficiency is excellent as compared with other structures. FIGS. 6A through 6C show test results. The experiments were performed with regard to an inventive example, a first comparative example, and a second comparative example.

The inventive example had the RBG structure of the pixel electrode-the hole transfer layer-the red light emitting layer-the blue light emitting layer-the green light emitting layer-the electron transfer layer-the common electrode structure. The first comparative example 1 had a BGR structure of the pixel electrode-the hole transfer layer-the blue light emitting layer-the green light emitting layer-the red light emitting layer-the electron transfer layer-the common electrode. The second comparative example had a GBR structure of the pixel electrode-the hole transfer layer-the green light emitting layer-the blue light emitting layer-the red light emitting layer-the electron transfer layer-the common electrode.

In the inventive example, the first comparative example and the second comparative example, the pixel electrode is in ohmic contact with the hole transfer layer, and the electron transfer layer is in ohmic contact with the common electrode.

FIG. 6A shows current density according to applied voltages. The RBG structure (inventive example) has higher current density than the BGR structure (first comparative example) and the GBR structure (second comparative example).

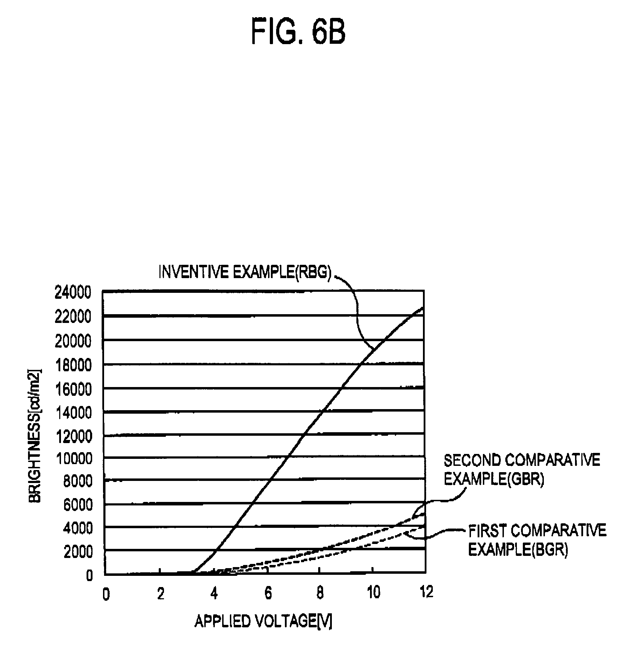

FIG. 6B shows brightness according to applied voltages. The RBG structure (inventive example) has higher brightness than the BGR structure (first comparative example) and the GBR structure (second comparative example).

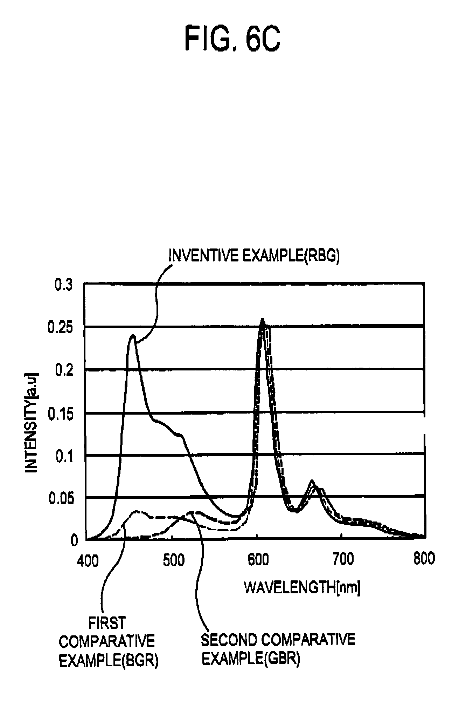

FIG. 6C shows intensity according to wavelengths. The BGR structure (first comparative example) and the GBR structure (second comparative example) have higher intensity at a red light wavelength range (about 600nm) than those at a green light wavelength range (about 530nm) and at a blue light wavelength range (about 450nm). This indicates that the charges supplied to the emitting material layer are not used throughout the entire emitting material layer, but mostly used in only the red light emitting layer.

On the other hand, in the RBG structure (inventive example), the intensity is balanced among the red, blue and green light wavelength ranges. This shows that the charges supplied to the emitting material layer are efficiently used throughout the entire emitting material layer.

It may be because the excitons of the blue light emitting layer having a relatively large energy band gap are efficiently distributed to both of its sides, i.e., to the red and green light emitting layers.

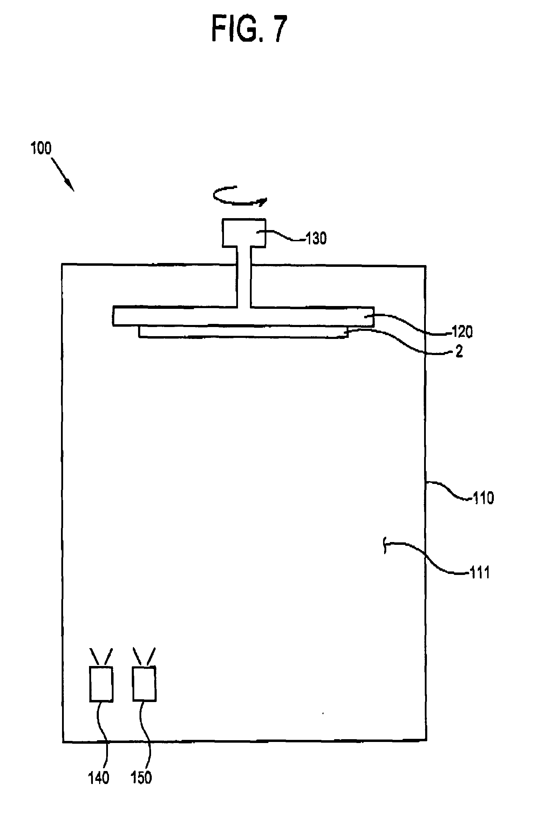

A manufacturing method of the display device according to the first embodiment of the present invention will be described with reference to FIG. 7.

FIG. 7 illustrates an evaporation apparatus to form a thin film having the host-dopant structure. In the first embodiment, the hole transfer layer 910, the emitting material layer 920 and the electron transfer layer 930 have the host-dopant structure.

The evaporation apparatus 100 includes a vacuum chamber 110 forming an evaporating space 111, a substrate supporter 120 placed above the evaporating space 111, and a driver 130 connected to the substrate supporter 120 and rotating the substrate supporter 120.

While forming the thin film, a substrate 2 to be formed with the thin film is mounted to the substrate supporter 120, and a first source 140 containing a host material and a second source 150 containing a dopant material are placed below the evaporating space 111.

If the first source 140 and the second source 150 are heated, vapor of the host material and the dopant material is supplied to the substrate 2. The vapor of the host and dopant materials contacts the substrate 2 and is cooled to form the thin film. While forming the thin film, the substrate 2 is rotated to thereby form the thin film uniformly.

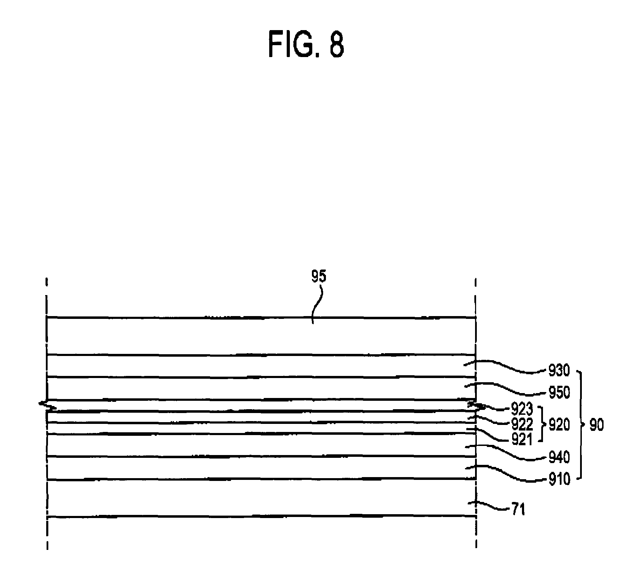

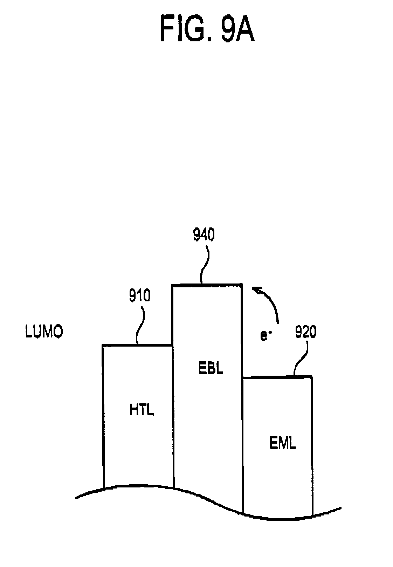

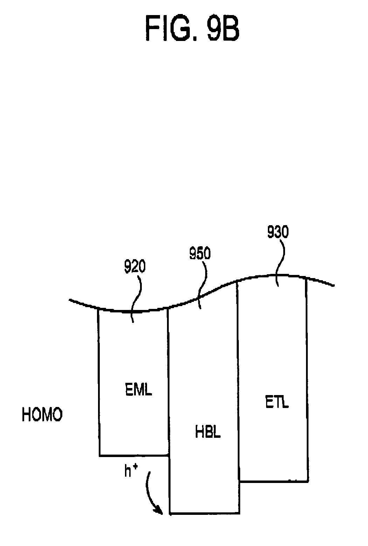

A display device according to a second embodiment of the present invention will be described with reference to FIGS. 8, 9A and 9B. FIG. 8 is an enlarged view corresponding to "A" of FIG. 2.

Referring to FIG. 8, a first blocking layer 940 is interposed between a hole transfer layer 910 and an emitting material layer 920, and a second blocking layer 950 is interposed between the emitting material layer 920 and the electron transfer layer 930.

The first blocking layer 940 includes a hole transfer material, and serves as an electron blocking layer (EBL). As shown in FIG. 9A, the first blocking layer 940 has a higher LUMO energy level than the hole transfer layer 910, so that it is difficult to move the electrons from the emitting material layer 920 to the first blocking layer 940. Accordingly, the first blocking layer 940 reduces the number of electrons that move to the hole transfer layer 910 without combining with the holes in the emitting material layer 920, thereby increasing charge efficiency.

The second blocking layer 950 includes an electron transfer material, and serves as a hole blocking layer (HBL). As shown in FIG. 9B, the second blocking layer 950 has a lower HOMO energy level than the electron transfer layer 930, so that it is difficult to move the holes from the emitting material layer 920 to the second blocking layer 950. Accordingly, the second blocking layer 950 reduces the number of holes that move to the electron transfer layer 930 without combining with the electrons in the emitting material layer 920, thereby increasing charge usage efficiency.

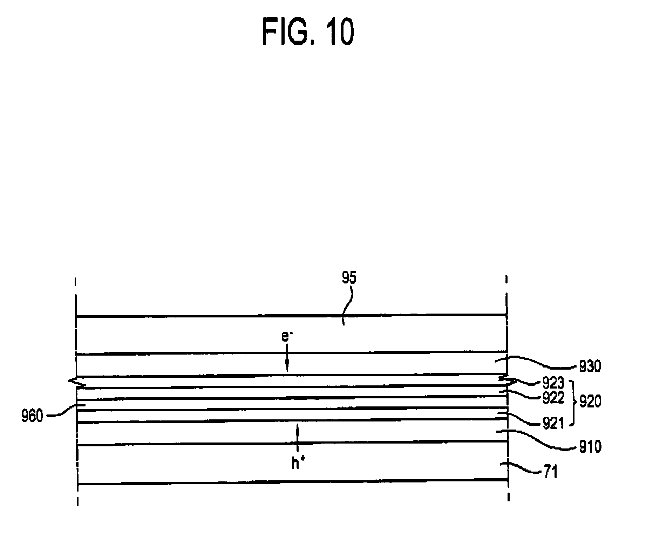

A third embodiment of the present invention will be described with reference to FIG. 10.

An intermediate layer 960 is formed between a red light emitting layer 921 and a blue light emitting layer 922. The intermediate layer 960 is capable of transferring holes. The intermediate layer 960 facilitates hole transfer from the red light emitting layer 921 to the blue light emitting layer 922.

Accordingly, the present invention enhances the charge efficiency. As the charge efficiency is enhanced, light efficiency increases and it is possible to lower a driving voltage, thereby decreasing power consumption.

As described above, the present invention provides a display device improved in charge efficiency.

Although a few embodiments of the present invention have been shown and described, it will be appreciated by those skilled in the art that changes may be made in these embodiments without departing from the principles and spirit of the invention, the scope of which is defined in the appended claims and their equivalents.

## Claims

1. A display device, comprising:
a first electrode;
a hole transfer layer which is formed on the first electrode, the hole transfer layer comprising a first host used as a hole transfer material and a first dopant used as an electron accepting material;
an emitting material layer which is formed on the hole transfer layer, the emitting material layer comprising red, blue and green light material layers stacked in sequence;
an electron transfer layer which is formed on the emitting material layer, the electron transfer layer comprising a second host used as an electron transfer material and a second dopant used as an electron donating material; and
a second electrode which is' formed on the electron transfer layer.

2. The display device according to claim 1, wherein a highest occupied molecular orbital (HOMO) of the first host has an energy level lower than an energy level of a lowest unoccupied molecular orbital (LUMO) of the first dopant.

3. The display device according to claim 1, wherein the first electrode and the hole transfer layer are in ohmic contact with each other.

4. The display device according to claim 1, wherein the first host comprises at least one of N,N'-di[(1-naphthalenyl)-N,N'-diphenyl]-1,1'-biphenyl-4,4'-diamine(NPD)), 9,10-bis(m-tolyphenylamino)anthracene (TPA), and spiro-TPA.

5. The display device according to claim 1, wherein the first dopant comprises tetrafluoro-tetracyano-quinodimethane (F4-TCNQ).

6. The display device according to claim 1, wherein the hole transfer layer is formed by an evaporation method using a source material of the first host and a source material of the first dopant.

7. The display device according to claim 1, wherein a lowest unoccupied molecular orbital (LUMO) of the second host has an energy level higher than an energy level of a highest occupied molecular orbital (HOMO) of the second dopant.

8. The display device according to claim 1, wherein the second electrode and the electron transfer layer are in ohmic contact with each other.

9. The display device according to claim 1, wherein the second host comprises tris(8-hydroxyquinolinolato)aluminum (Alq3).

10. The display device according to claim 1, wherein the second dopant comprises at least one of cesium (Cs), barium (Ba) and calcium (Ca).

11. The display device according to claim 1, wherein the electron transfer layer is formed by an evaporation method using a source material of the second host and a source material of the second dopant.

12. The display device according to claim 1, wherein at least one of the red, blue and green light emitting layers has a structure of light emitting host-light emitting dopant.

13. The display device according to claim 1, wherein the emitting material layer is formed by an evaporation method.

14. The display device according to claim 1, further comprising a color filter disposed on an optical path of light emitted from the emitting material layer.

15. The display device according to claim 1, further comprising a first blocking layer which is interposed between the hole transfer layer and the emitting material layer, the first blocking layer having an energy level of the lowest unoccupied molecular orbital (LUMO) higher than that of the hole transfer layer.

16. The display device according to claim 1, further comprising a second blocking layer which is interposed between the electron transfer layer and the emitting material layer, the second blocking layer having an energy level of the highest occupied molecular orbital (HOMO) lower than that of the electron transfer layer.

17. The display device according to claim 1, wherein the first electrode comprises a transparent conductive material, and the second electrode comprises a reflective metal.

18. The display device according to claim 1, further comprising an intermediate layer which is interposed between the red light emitting layer and the blue light emitting layer and transfers holes.

19. A display device, comprising:
a first electrode;
a hole transfer layer which is formed on the first electrode;
an emitting material layer which is formed on the hole transfer layer;
an electron transfer layer which is formed on the emitting material layer; and
a second electrode which is formed on the electron transfer layer,
the emitting material layer comprising red, blue and green light emitting layers stacked in sequence, and
at least one of contact between the hole transfer layer and the first electrode and contact between the electron transfer layer and the second electrode being ohmic contact.

20. The display device according to claim 19, wherein the hole transfer layer comprises a first host used as a hole transfer material and a first dopant used as an electron accepting material, and
a highest occupied molecular orbital (HOMO) of the first host has an energy level lower than an energy level of a lowest unoccupied molecular orbital (LUMO) of the first dopant.

21. The display device according to claim 19, wherein the electron transfer layer comprises a second host used as an electron transfer material and a second dopant used as an electron donating material, and
a lowest unoccupied molecular orbital (LUMO) of the second host has an energy level higher than an energy level of a highest occupied molecular orbital (HOMO) of the second dopant.
